# EUROPÄISCHE PATENTANMELDUNG

(11) **EP 3 244 279 A1**
(43) Veröffentlichungstag der Anmeldung: **15.11.2017**
(21) Anmeldenummer: 16169534.1
(22) Anmeldetag: 13.05.2016
(51) Int. Cl.: G05B 23/02, H02H 3/00

(54) **VERFAHREN ZUM BETREIBEN EINES FEHLERINDIKATORS**

(71) Anmelder: Siemens Aktiengesellschaft, 80333 München (DE)
(72) Erfinder: Fröhner, Wiebke, 92224 Amberg (DE); Werner, Thomas, 91126 Rednitzhembach (DE)

(57) **Zusammenfassung**

Die Erfindung bezieht sich u. a. auf ein Verfahren zum Betreiben eines Fehlerindikators (100), insbesondere Fehlerstromindikators, der einen Fehler in einer elektrischen Energieübertragungsleitung (21), insbesondere einen Fehlerstrom in der Energieübertragungsleitung (21), erkennen kann und im Falle eines erkannten Fehlers ein Fehlersignal (F) zu einer übergeordneten, die Energieübertragungsleitung (21) überwachenden Leitzentrale (110) sendet.

Erfindungsgemäß ist vorgesehen, dass der Fehlerindikator (100) regelmäßig oder unregelmäßig zumindest eine lokale Wetterinformation (W), die sich auf das Wetter im Umfeld des Fehlerindikators (100) bezieht, zu der übergeordneten Leitzentrale (110), direkt zu einer anderen Zentraleinrichtung als der Leitzentrale (110) oder mittelbar über die Leitzentrale (110) zu der anderen Zentraleinrichtung übersendet.

## Beschreibung

Die Erfindung bezieht sich u. a. auf ein Verfahren zum Betreiben eines Fehlerindikators, insbesondere Fehlerstromindikators, der einen Fehler in einer elektrischen Energieübertragungsleitung, insbesondere einen Fehlerstrom in der Energieübertragungsleitung, erkennen kann und im Falle eines erkannten Fehlers ein Fehlersignal zu einer übergeordneten, die Energieübertragungsleitung überwachenden Leitzentrale sendet.

Zur Erkennung von Fehlern in Mittelspannungsfreileitungen können bekanntermaßen Fehlerindikatoren (englischsprachig auch Fault Passage Indicator genannt) eingesetzt werden, die das Magnetfeld der Leitung mit einer induktiven Kopplung überwachen und bei Durchgang eines Fehlerstroms (beispielsweise im Falle eines Erdschlusses oder Kurzschlusses) ein Signal auslösen. Die ersten Fehlerindikatoren dieser Art wurden bereits Ende der 40er Jahre eingesetzt. Diese waren zwar in der Anschaffung billig, sie stellen jedoch im Falle eines Fehlers lokal nur ein optisches Signal zur Verfügung. Tritt ein Fehler auf, so muss im Rahmen der Fehlersuche der Leitungsverlauf von Wartungsmannschaften abgelaufen werden, bis die Fehlerstelle gefunden worden ist. Um ein solches Ablaufen zu vermeiden, setzt man seit einigen Jahren auch Fehlerindikatoren ein, die mit einem eigenen Kommunikationsmodul, insbesondere in Form eines eigenen Gateways, ausgerüstet sind und ihre Informationen zu einem zentralen Leitsystem, hier nachfolgend Leitzentrale genannt, übertragen.

Die neu eingesetzten kommunikationsfähigen Fehlerindikatoren sind jedoch von der Anschaffung und im Betrieb deutlich teurer als die früher eingesetzten, nicht kommunikationsfähigen Fehlerindikatoren; aus diesem Grunde werden in der Regel kommunikationsfähige Fehlerindikatoren derzeit meist nur an ausgewählten, in der Regel schlecht zugänglichen, Stellen im Energieübertragungsnetz installiert.

Der Erfindung liegt die Aufgabe zugrunde, ein Verfahren zum Betreiben von Fehlerindikatoren anzugeben, das deren Einsatz attraktiver als bisher macht.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass der Fehlerindikator regelmäßig oder unregelmäßig zumindest eine lokale Wetterinformation, die sich auf das Wetter im Umfeld des Fehlerindikators bezieht, zu der übergeordneten Leitzentrale, direkt zu einer anderen Zentraleinrichtung als der Leitzentrale oder mittelbar über die Leitzentrale zu der anderen Zentraleinrichtung übersendet.

Ein wesentlicher Vorteil des erfindungsgemäßen Verfahrens ist darin zu sehen, dass die Fehlerindikatoren nicht allein zum Erzeugen und Weiterleiten von Fehlersignalen herangezogen werden, sondern darüber hinaus auch zur Weitergabe lokaler Wetterinformationen. Die für den Betrieb der Fehlerindikatoren nötige Infrastruktur lässt sich somit bei dem erfindungsgemäßen Verfahren doppelt nutzen, nämlich zum einen zur Übertragung der Fehlersignale und zum anderen zur Übertragung der lokalen Wetterinformationen.

Um die vorhandene Infrastruktur mit möglichst minimalem Anpassungsaufwand weiter betreiben zu können, wird es als vorteilhaft angesehen, wenn die zumindest eine lokale Wetterinformation mit demselben Kommunikationsprotokoll und auf demselben Kommunikationskanal übertragen wird wie die Fehlersignale im Falle eines Fehlers.

Mit Blick auf eine zentrale Weiterverarbeitung der Wetterinformationen wird es als vorteilhaft angesehen, wenn die zumindest eine lokale Wetterinformation zu einer Zentraleinrichtung in Form eines zentralen Cloud-Systems übersandt wird.

Bezüglich der cloudseitigen Behandlung der lokalen Wetterinformationen wird es als vorteilhaft angesehen, wenn diese in einer Datenbank des zentralen Cloud-Systems gespeichert werden und/oder mit Visualisierungsmitteln des zentralen Cloud-Systems - allein oder mit anderen Wetterinformationen, insbesondere Wetterinformationen anderer Quellen - visualisiert werden.

Darüber hinaus ist es in vorteilhafter Weise möglich, die lokalen Wetterinformationen allein oder gemeinsam mit Wetterinformationen aus anderen Quellen zur Erstellung einer Wetterprognose heranzuziehen und eine Wetterprognose zu erstellen, die bezüglich des Umfeldes des Fehlerindikators messwertbezogen lokal fundierter ist als eine Wetterprognose ohne die zusätzlichen lokalen Wetterinformationen der Fehlerindikators.

Die lokalen Wetterinformationen können darüber hinaus im Rahmen eines Prognoseverbesserungsverfahrens weiterverarbeitet werden, bei dem auf der Basis einer zuvor erstellten globalen oder regionalen Wetterprognose unter Berücksichtigung der lokalen Wetterinformationen eine lokal modifizierte Wetterprognose erstellt wird.

Die mit den lokalen Wetterinformationen erstellte Wetterprognose oder die lokal modifizierte Wetterprognose kann in vorteilhafter Weise zur Steuerung der Einspeisung von Energie in ein Energieübertragungsnetz herangezogen werden. Beispielsweise kann anhand der lokalen Wetterinformationen die Einspeisung von Energie in dasjenige Energieübertragungsnetz gesteuert werden, das mit dem Fehlerindikator auch hinsichtlich von Fehlern, insbesondere Fehlerströmen, überwacht wird.

Alternativ oder zusätzlich können die lokalen Wetterinformationen zur Steuerung von Heizungsanlagen herangezogen werden.

Ein Prognoseverfahren zur Bildung einer Wetterprognose anhand der lokalen Wetterinformationen und/oder ein Prognoseverbesserungsverfahren kann in vorteilhafter Weise mittels eines künstlichen neuronalen Netzes, z. B. auf der Basis eines Multilayer-Perzeptronen-Modells oder statistischer Verfahren wie der Support Vector Machines durchgeführt werden.

Im Falle eines Einsatzes eines künstlichen neuronalen Netzes wird es als vorteilhaft angesehen, wenn ein Netz mit mindestens drei Schichten genutzt wird, von denen die Eingangsschicht und die Ausgangsschicht des Netzes jeweils über die gleiche Anzahl an Perzeptronen verfügen; jedes Perzeptron repräsentiert dabei jeweils eine Variable der Wetterprognose pro Zeitintervall.

Im Rahmen eines Prognoseverbesserungsverfahrens können an die Eingangsschicht beispielsweise eine zuvor erstellte globale oder regionale Wetterprognose sowie die lokalen Wetterdaten der Fehlerindikatoren eingegeben werden, indem die Perzeptronen der Eingangsschicht mit den entsprechenden Wetterdaten beaufschlagt werden. Die von dem neuronalen Netz ermittelte lokal modifizierte Wetterprognose wird mittels der Perzeptronen der Ausgangsschicht ausgegeben.

Das künstliche neuronale Netz wird vor der Durchführung des Prognoseverfahrens bzw. des Prognoseverbesserungsverfahrens vorzugsweise mit Hilfe der Backpropagation-Methode und gemessenen Wetterdaten als Trainingsdaten trainiert.

Der Fehlerindikator oder zumindest dessen Kommunikationsmodul (z. B. Gateway) wird vorzugsweise mit Solarenergie betrieben, die mittels einer Solarzelle des Fehlerindikators gewonnen wird. Auch ist es vorteilhaft, wenn die jeweilige Leistungsabgabe der Solarzelle als Maß für die jeweilige solare Einstrahlung herangezogen und anhand der jeweiligen Leistungsabgabe ein solarer Einstrahlungsmesswert erzeugt wird. Der solare Einstrahlungsmesswert wird vorzugsweise als die zumindest eine lokale Wetterinformation oder eine der lokalen Wetterinformationen an die Leitzentrale und/oder die Zentraleinrichtung übersandt.

Auch kann der Fehlerindikator einen oder mehrere weitere Wettersensoren, insbesondere einen Regenmesser, einen Windmesser, einen Temperaturfühler und/oder Luftdrucksensor, aufweisen, deren Sensorsignale als lokale Wetterinformationen an die Leitzentrale und/oder die Zentraleinrichtung übersandt werden.

Bei einer weiteren vorteilhaften Ausgestaltung ist vorgesehen, dass der Fehlerindikator zusätzlich zu einem Kommunikationsmodul, insbesondere Gateway, das zum Senden des Fehlersignals an die Leitzentrale geeignet ist, eine zusätzliche Kommunikationseinrichtung, insbesondere Nahfeldkommunikationseinrichtung, umfasst.

Mittels einer solchen zusätzlichen Kommunikationseinrichtung wird vorzugsweise eine Datenverbindung, insbesondere in Form einer Funkverbindung, zwischen mindestens einem Strom- und/oder Spannungssensor des Fehlerindikators und dem Kommunikationsmodul des Fehlerindikators unterhalten, um die Messwerte des Strom- und/oder Spannungssensors und/oder ein daraus bereits sensorseitig gebildetes Fehlersignal zwecks Weiterleitung an die Leitzentrale zu dem Kommunikationsmodul bzw. Gateway zu übermitteln.

Alternativ oder zusätzlich kann mittels einer solchen zusätzlichen Kommunikationseinrichtung eine Datenverbindung, insbesondere in Form einer Funkverbindung, zwischen mindestens einem externen Wettersensor und dem Kommunikationsmodul des Fehlerindikators unterhalten werden, um Wetterinformationen des externen Wettersensors zwecks Weiterleitung an die Leitzentrale zu dem Kommunikationsmodul bzw. Gateway zu übermitteln.

Mit anderen Worten kann also vorgesehen sein, dass der Fehlerindikator dauerhaft oder zumindest zeitweise, insbesondere regelmäßig oder unregelmäßig, mittels der Kommunikationseinrichtung mit einem oder mehreren externen Wettersensoren in einer Kommunikationsverbindung steht, die Sensorsignale der externen Wettersensoren über die Kommunikationsverbindung zu dem Fehlerindikator übertragen werden und die Sensorsignale anschließend von dem Kommunikationsmodul bzw. Gateway des Fehlerindikators als lokale Wetterinformationen an die Leitzentrale und/oder die Zentraleinrichtung weitergeleitet werden.

Zum Zwecke der Überwachung eines Energieübertragungsnetzes werden zusätzlich zu dem mindestens einen Fehlerindikator vorzugsweise weitere Fehlerindikatoren betrieben, die jeweils dieselbe elektrische Energieübertragungsleitung wie der Fehlerindikator oder eine andere mit dieser mittelbar oder unmittelbar in Verbindung stehende elektrische Energieübertragungsleitung desselben Energieübertragungsnetzes überwachen und im Falle eines Fehlers mittels ihres Kommunikationsmoduls jeweils ein Fehlersignal zu der übergeordneten Leitzentrale senden. Jeder der Fehlerindikatoren übersendet vorzugsweise jeweils über sein Kommunikationsmodul regelmäßig oder unregelmäßig außerdem zumindest eine lokale Wetterinformation, die sich auf das Wetter im Umfeld des jeweiligen Fehlerindikators bezieht, zu der Leitzentrale oder unmittelbar oder mittelbar über die Leitzentrale zu einer Zentraleinrichtung. Die Übermittlung der lokalen Wetterinformationen erfolgt vorzugsweise jeweils mit demselben Kommunikationsprotokoll und auf demselben Kommunikationskanal, das bzw. der zur Übermittlung der Fehlersignale genutzt wird. Im Falle eines Empfangs von einem oder mehreren Fehlersignalen bestimmt die Leitzentrale anhand der Fehlersignale die vom Fehler betroffenen Abschnitte des Energieübertragungsnetzes.

Die lokalen Wetterinformationen der Fehlerindikatoren werden vorzugsweise in einer Datenbank eines zentralen Cloud-Systems gespeichert und/oder visualisiert und/oder zur Erstellung einer Wetterprognose herangezogen und/oder zur Erstellung einer lokal modifizierten Wetterprognose herangezogen, beispielsweise auf der Basis einer zuvor erstellten globalen oder regionalen Wetterprognose und auf der Basis der lokalen Wetterinformationen, die die Fehlerindikatoren liefern.

Die Erfindung bezieht sich darüber hinaus auf einen Fehlerindikator zum Erkennen eines Fehlers in einer elektrischen Energieübertragungsleitung, insbesondere eines Fehlerstroms in der Energieübertragungsleitung, und zum Senden eines Fehlersignals zu einer übergeordneten, die Energieübertragungsleitung überwachenden Leitzentrale im Falle eines erkannten Fehlers.

Bezüglich eines solchen Fehlerindikators ist erfindungsgemäß vorgesehen, dass der Fehlerindikator derart ausgestaltet ist, das er mittels eines Kommunikationsmoduls regelmäßig oder unregelmäßig zumindest eine lokale Wetterinformation, die sich auf das Wetter im Umfeld des Fehlerindikators bezieht, zu der übergeordneten Leitzentrale, direkt zu einer anderen Zentraleinrichtung als der Leitzentrale oder mittelbar über die Leitzentrale zu der Zentraleinrichtung übersendet.

Bezüglich der Vorteile des erfindungsgemäßen Fehlerindikators sei auf die obigen Ausführungen im Zusammenhang mit dem erfindungsgemäßen Verfahren verwiesen.

Bezüglich der Ausgestaltung des Fehlerindikators wird es als vorteilhaft angesehen, wenn der Fehlerindikator einen oder mehrere Wettersensoren aufweist, deren Sensorsignale als lokale Wetterinformationen an die Leitzentrale und/oder die Zentraleinrichtung übersandt werden.

Alternativ oder zusätzlich kann der Fehlerindikator derart ausgestaltet sein, dass er dauerhaft oder zeitweise mit einem oder mehreren externen Wettersensoren in einer Kommunikationsverbindung stehen kann, und empfangene Sensorsignale der externen Wettersensoren über sein Kommunikationsmodul als lokale Wetterinformationen an die Leitzentrale und/oder die Zentraleinrichtung weiterleitet.

Die Erfindung bezieht sich darüber hinaus auf eine Überwachungseinrichtung zur Überwachung eines Energieübertragungsnetzes mit einer Vielzahl an Fehlerindikatoren, die elektrische Energieübertragungsleitungen eines Energieübertragungsnetzes überwachen und im Falle eines Fehlers jeweils mittels eines Kommunikationsmoduls ein Fehlersignal zu einer übergeordneten Leitzentrale der Überwachungseinrichtung senden.

Bezüglich der Ausgestaltung der Überwachungseinrichtung ist erfindungsgemäß vorgesehen, dass die Fehlerindikatoren so ausgestaltet sind, wie dies oben erläutert worden ist.

Die Erfindung wird nachfolgend anhand von Ausführungsbeispielen näher erläutert; dabei zeigen beispielhaft
- Figur 1: ein Ausführungsbeispiel für eine Überwachungseinrichtung, mit der sich ein Energieübertragungsnetz überwachen lässt,
- Figur 2: ein Ausführungsbeispiel für einen Fehlerindikator, der bei der Überwachungseinrichtung gemäß Figur 1 eingesetzt werden kann,
- Figur 3: ein weiteres Ausführungsbeispiel für einen Fehlerindikator, der bei der Überwachungseinrichtung gemäß Figur 1 eingesetzt werden kann,
- Figur 4: ein Ausführungsbeispiel für ein zentrales Cloudsystem, das mit der Überwachungseinrichtung gemäß Figur 1 verbunden sein kann, und
- Figur 5: ein Ausführungsbeispiel für ein neuronales Netz, das zur Erstellung einer Wetterprognose oder zur lokalen Verbesserung bzw. Präzisierung einer globalen oder regionalen Wetterprognose genutzt werden kann.

In den Figuren werden der Übersicht halber für identische oder vergleichbare Komponenten stets dieselben Bezugszeichen verwendet.

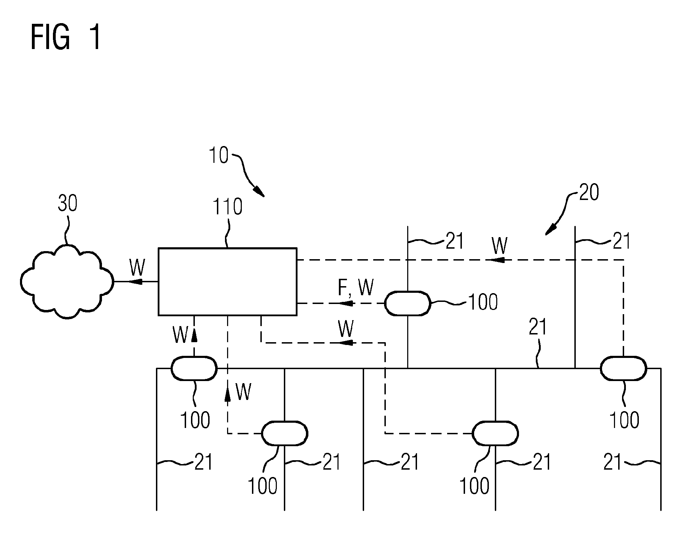

Die Figur 1 zeigt eine Überwachungseinrichtung 10, mit der ein Energieübertragungsnetz 20 überwacht wird. Das Energieübertragungsnetz 20 wird durch eine Vielzahl an Energieübertragungsleitungen 21 gebildet, die miteinander in Verbindung stehen.

Die Überwachungseinrichtung 10 umfasst eine Vielzahl an Fehlerindikatoren 100, die jeweils einer der Energieübertragungsleitungen 21 zugeordnet sind und jeweils mit einer Leitzentrale 110 der Überwachungseinrichtung 10 in Verbindung stehen. Im Falle eines Fehlers erzeugen diejenigen Fehlerindikatoren 100, die einen Fehler feststellen, ein Fehlersignal F und übertragen dieses zur Leitzentrale 110. Anhand der eingehenden Fehlersignale F kann die Leitzentrale 110 den Fehlerort innerhalb des Energieübertragungsnetzes 20 lokalisieren und ggf. durch Abschalten einzelner Energieübertragungsleitungen 21 den fehlerbehafteten Abschnitt des Energieübertragungsnetzes 20 vom übrigen Energieübertragungsnetz 20 abtrennen.

Die Fehlerindikatoren 100 sind darüber hinaus derart ausgestaltet, dass sie dauerhaft oder zumindest zeitweise, sei es regelmäßig oder unregelmäßig, lokale Wetterinformationen W erzeugen und diese an die Leitzentrale 110 übermitteln. Die lokalen Wetterinformationen W werden von den Fehlerindikatoren 100 vorzugsweise genauso übermittelt wie die Fehlersignale F im Falle eines Fehlers, also vorzugsweise auf demselben Kommunikationskanal und mit demselben Kommunikationsprotokoll wie die Fehlersignale F.

Die lokale Wetterinformationen W werden vorzugsweise in Form von Messwerten bzw. Messwertsignalen wie beispielsweise Temperaturmesswerten, Druckmesswerten, Niederschlagsmesswerten, Windmesswerten, etc. übermittelt.

Die Leitzentrale 110 leitet bei dem Ausführungsbeispiel gemäß Figur 1 die Wetterinformationen W an eine Zentraleinrichtung in Form eines zentralen Cloudsystems 30 weiter. In dem zentralen Cloudsystem 30 können die lokalen Wetterinformationen W gespeichert und/oder mit Visualisierungsmitteln des zentralen Cloudsystems 30 visualisiert werden. Darüber hinaus ist es möglich, in dem zentralen Cloudsystem 30 auf der Basis der lokalen Wetterinformation W eine Wetterprognose zu erstellen oder eine bereits erstellte globale oder regionale Wetterprognose anhand der lokalen Wetterinformationen W lokal zu verfeinern bzw. zu präzisieren.

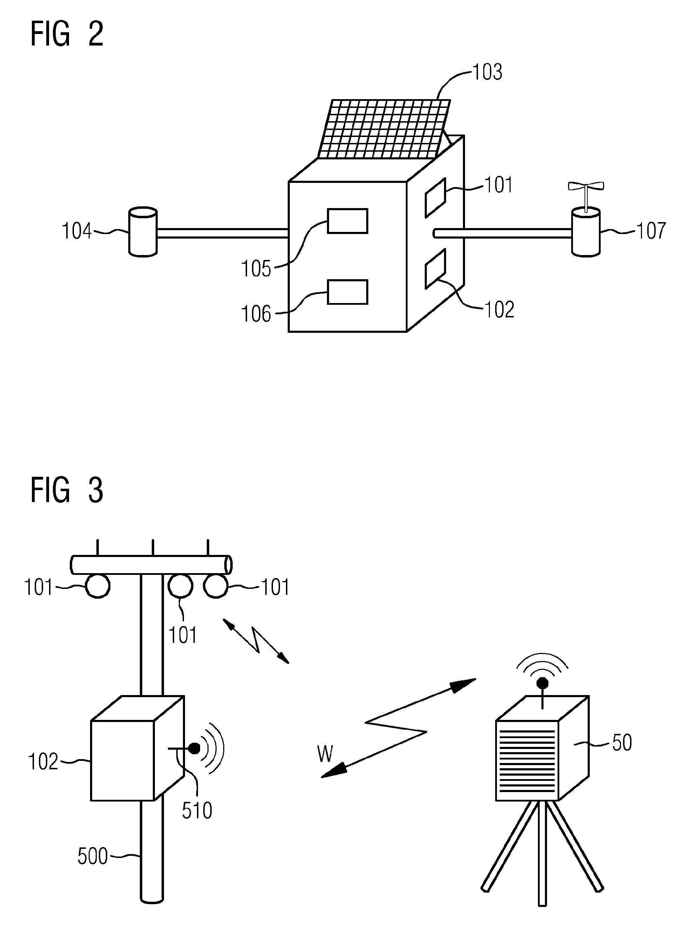

Die Figur 2 zeigt ein Ausführungsbeispiel für einen Fehlerstromindikator, der bei der Überwachungseinrichtung 10 gemäß Figur 1 als Fehlerindikator 100 eingesetzt werden kann. Der Fehlerstromindikator umfasst Stromsensoren 100, mit denen der Strom durch die vom Fehlerstromindikator überwachte Energieübertragungsleitung 21 gemäß Figur 1 gemessen werden kann; anhand der Messergebnisse können Fehler, insbesondere beispielsweise Erdschlüsse oder Kurzschlüsse, erkannt werden und ggf. kann ein Fehlersignal F erzeugt werden.

Die Stromsensoren 100 des Fehlerstromindikators stehen mit einem fehlerindikatoreigenem Kommunikationsmodul in Form eines Gateways 102 in Verbindung, das eine Übertragung des Fehlersignals F, beispielsweise leitungsgebunden oder per Funk, zur Leitzentrale 110 gemäß Figur 1 ermöglicht.

Zur Stromversorgung ist der Fehlerstromindikator gemäß Figur 2 mit einer Solarzelle 103 ausgestattet. Die jeweilige Leistungsabgabe der Solarzelle 103 wird von dem Fehlerstromindikator als Maß für die jeweilige solare Einstrahlung herangezogen, und es wird anhand der jeweiligen Leistungsabgabe der Solarzelle 103 ein solarer Einstrahlungsmesswert erzeugt, der als lokale Wetterinformation W an die Leitzentrale 110 gemäß Figur 1 übermittelt wird. Die Solarzelle 103 wird also doppelt genutzt, nämlich als Generator und als Wettersensor.

Darüber hinaus ist der Fehlerstromindikator mit einer Vielzahl an weiteren Wettersensoren ausgestattet, von denen in der Figur 2 beispielhaft ein Regenmesser 104, ein Temperaturfühler 105, ein Luftdrucksensor 106 und ein Windmesser 107 dargestellt sind. Die Sensorsignale dieser Wettersensoren werden als lokale Wetterinformationen W an die Leitzentrale 110 gemäß Figur 1 übersandt.

Bei dem Ausführungsbeispiel gemäß Figur 2 ist der Fehlerstromindikator also selbst mit Wettersensoren ausgestattet, deren Sensorsignale als lokale Wetterinformationen W weitergeleitet werden.

Die Figur 3 zeigt ein weiteres Ausführungsbeispiel für einen Fehlerstromindikator, der als Fehlerindikator 100 bei dem Energieübertragungsnetz 20 gemäß Figur 1 eingesetzt werden kann. Bei dem Fehlerstromindikator sind an einem Mast 500 befestigte Stromsensoren 101 und das Gateway 102 beabstandet voneinander angeordnet und kommunizieren über eine Nahbereichskommunikationsverbindung, z. B. Zigbee o. ä., miteinander. Über die Nahbereichskommunikationsverbindung werden die Sensordaten der Stromsensoren 101 zum Gateway 102 übermittelt, das im Falle eines Fehlers ein Fehlersignal F zur Leitzentrale 110 gemäß Figur 1 übermittelt. Die Auswertung der Sensordaten der Stromsensoren 101 zum Zwecke der Fehlererkennung und Fehlersignalerzeugung kann sensorseitig oder gatewayseitig erfolgen.

Zum Betrieb der Nahbereichskommunikationsverbindung weist der Fehlerstromindikator eine zusätzliche Kommunikationseinrichtung 510, hier in Form einer Nahfeldkommunikationseinrichtung, auf.

Das Gateway 102 steht über eine Nahbereichskommunikationsverbindung darüber hinaus mit einer externen Wetterstation 50 in Verbindung, von der das Gateway 102 externe lokale Wetterdaten W erhält. Die externen lokalen Wetterdaten W werden vom Gateway 102 zu der Leitzentrale 110 gemäß Figur 1 weitergeleitet.

Bei dem Ausführungsbeispiel gemäß Figur 3 hat das Gateway 102 des Fehlerstromindikators also eine doppelte Schnittstellenfunktion, denn es bildet sowohl eine Schnittstelle zu den Stromsensoren 101 als auch eine Schnittstelle zu der externen Wetterstation 50.

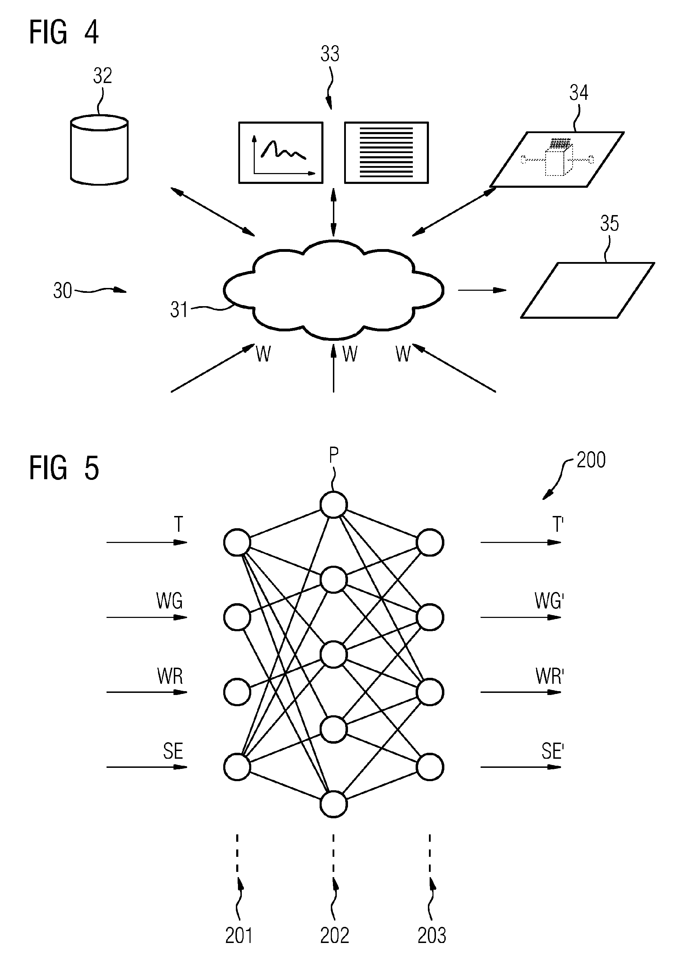

Die Figur 4 zeigt ein Ausführungsbeispiel für ein zentrales Cloudsystem 30 näher im Detail. Das zentrale Cloudsystem 30 umfasst eine Cloud 31, in die die lokalen Wetterinformationen W der Fehlerindikatoren 100 gemäß Figur 1 eingespeist werden.

Cloudseitig stellt das zentrale Cloudsystem 30 vorzugsweise eine Datenbank 32 zum Speichern der lokalen Wetterinformationen W, Visualisierungsmittel 33 zur Visualisierung der lokalen Wetterinformationen W, Prognosemittel 34 zum Erstellen einer Wetterprognose unter Heranziehung der lokalen Wetterinformationen W sowie Prognoseanpassungsmittel 35 zur lokalen Verbesserung einer regionalen oder globalen Wetterprognose zur Verfügung.

Die Datenbank 32 kann über geeignete Schnittstellen beispielsweise Dritten einen Zugang zu den lokalen Wetterinformationen ermöglichen, damit diese eine Auswertung der Daten extern durchführen können. Beispielsweise kann unter Heranziehung der lokalen Wetterinformationen W extern eine Wetterprognose erstellt oder eine erstellte regionale oder globale Wetterprognose extern verfeinert werden.

Die Visualisierungsmittel 33 können beispielsweise eine geografisch orientierte Darstellung der Wetterinformationen ermöglichen. Beispielsweise können die Positionen der Fehlerindikatoren auf einer Karte angezeigt werden. Durch Anklicken der Positionen können Fenster geöffnet werden, in denen die lokalen Wetterinformationen präsentiert werden.

Die Figur 5 zeigt ein Ausführungsbeispiel für ein neuronales Netz 200, das zur Realisierung der Prognosemittel 34 bzw. der Prognoseanpassungsmittel 35 gemäß Figur 4 genutzt werden kann.

Das neuronale Netz 200 umfasst bei dem Ausführungsbeispiel gemäß Figur 5 drei Schichten 201, 202 und 203. Die Eingangsschicht 201 und die Ausgangsschicht 203 des neuronalen Netzes 200 weisen vorzugsweise jeweils die gleiche Anzahl an Perzeptronen P auf. Jedes Perzeptron P der Eingangsschicht 201 repräsentiert eine Variable einer bereits erstellten globalen oder regionalen Wetterprognose pro Zeitintervall. Die Ausgangsschicht 203 bzw. die Perzeptronen P der Ausgangsschicht 203 dienen zur Ausgabe der von dem neuronalen Netz 200 ermittelten lokalen Wetterprognose bzw. zur Ausgabe der von dem neuronalen Netz 200 lokal angepassten bzw. lokal modifizierten Wetterprognose.

Bei der Darstellung gemäß Figur 5 wird beispielhaft für ein Zeitintervall davon ausgegangen, dass an die Eingangsschicht 201 im Rahmen einer anderweitig erstellten Wetterprognose prognostizierte Temperaturmesswerte T, im Rahmen einer anderweitig erstellten Wetterprognose prognostizierte Windgeschwindigkeiten WG, im Rahmen einer anderweitig erstellten Wetterprognose prognostizierte Windrichtungsangaben WR, im Rahmen einer anderweitig erstellten Wetterprognose prognostizierte solare Einstrahlungswerte SE eingespeist werden. An der Ausgangsschicht 203 werden die korrespondierenden Prognosewerte in Form prognostizierter oder durch lokale Wetterinformationen angepasster prognostizierter Temperaturmesswerte T', prognostizierter oder durch lokale Wetterinformationen angepasster prognostizierter Windgeschwindigkeiten WG', prognostizierter oder durch lokale Wetterinformationen angepasster prognostizierter Windrichtungsangaben WR' und prognostizierter oder durch lokale Wetterinformationen angepasster prognostizierter solarer Einstrahlungswerte SE' ausgegeben.

Das neuronale Netz 200 wird vorzugsweise mit Hilfe der Backpropagation-Methode und anhand gemessener Wetterdaten als Trainingsdaten trainiert.

Zusammengefasst besteht bei den Ausführungsbeispielen gemäß den Figuren 1 bis 5 der Grundgedanke darin, Fehlerindikatoren, insbesondere Fehlerstromindikatoren, zur Aufnahme von Wetterdaten zu nutzen, um mit diesen Informationen cloudbasierte Dienstleistungen erbringen zu können. Zu diesen Dienstleistungen können u. a. die Weitergabe der gemessenen lokalen Wetterdaten an Wetterdienste sowie die Berechnung von lokalen Wetterprognosen gehören.

Potentielle Kunden für die gemessenen Wetterdaten können z. B. nationale oder private Wetterdienste sein. Diese betreiben derzeit noch selbst ein aufwendiges Netz aus Wetterstationen, die mit einer eigenen Kommunikationstechnik versehen sein müssen und entsprechend auch gewartet werden müssen.

Neben den erfassten lokalen Wetterdaten können auch verbesserte lokale Wetterprognosen als Dienstleistungen angeboten werden. Als Kunden hierfür kommen beispielsweise die Betreiber von elektrischen Verteilnetzen in Frage, die Wetterdaten bei der Betriebsführung ihrer Netze berücksichtigen. Diese Prognosen können insbesondere dann relevant sein, wenn aufgrund fehlender Netzkapazitäten steuernd in den Betrieb der Anlagen eingegriffen werden muss.

An einer verbesserten lokalen Wetterprognose werden darüber hinaus auch die Betreiber virtueller Kraftwerke interessiert sein, in deren Portfolio sich regenerative dezentrale Erzeugungsanlagen befinden.

Eine weitere Zielgruppe für die oben erwähnten verbesserten lokalen Wetterprognosen können darüber hinaus die Betreiber von Heizungsanlagen sein. Aktuell werden in der Regel Heizungen auf der Basis der jeweils aktuellen Außentemperatur geregelt. Ein angenehmeres Raumklima und geringere Heizungskosten lassen sich jedoch erreichen, wenn eine Steuerung der Heizleistung nicht nur anhand der jeweils aktuellen Außentemperatur, sondern darüber hinaus auch anhand einer lokal genauen Temperaturprognose erfolgt. Auch ist es möglich, die Steuerung der Heizleistung ausschließlich anhand einer lokal genauen Temperaturprognose durchzuführen, wodurch sich individuelle Außentemperatursensoren einsparen lassen.

Zusammengefasst lässt sich der technische und wirtschaftliche Nutzen von Fehlerindikatoren durch die zusätzliche Generierung und/oder Weiterleitung von lokalen Wetterinformationen deutlich verbessern.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Überwachungseinrichtung
- 20: Energieübertragungsnetz
- 21: Energieübertragungsleitungen
- 30: Cloudsystem, Zentraleinrichtung
- 31: Cloud
- 32: Datenbank
- 33: Visualisierungsmittel
- 34: Prognosemittel
- 35: Prognoseanpassungsmittel
- 50: Wetterstation
- 100: Fehlerindikatoren, Stromsensoren
- 101: Stromsensoren
- 102: Gateway, Kommunikationsmodul
- 103: Solarzelle
- 104: Regenmesser
- 105: Temperaturfühler
- 106: Luftdrucksensor
- 107: Windmesser
- 110: Leitzentrale
- 200: Netz
- 201: Schicht
- 202: Schicht
- 203: Schicht
- 500: Mast
- 510: zusätzliche Kommunikationseinrichtung

- F: Fehlersignal
- P: Perzeptronen
- SE: solare Einstrahlungswerte
- SE': solare Einstrahlungswerte
- T: Temperaturmesswerte
- T': Temperaturmesswerte
- W: Wetterinformationen
- WG: Windgeschwindigkeiten
- WG': Windgeschwindigkeiten
- WR: Windrichtungsangaben
- WR': Windrichtungsangaben

## Patentansprüche

1. Verfahren zum Betreiben eines Fehlerindikators (100), insbesondere Fehlerstromindikators, der einen Fehler in einer elektrischen Energieübertragungsleitung (21), insbesondere einen Fehlerstrom in der Energieübertragungsleitung (21), erkennen kann und im Falle eines erkannten Fehlers ein Fehlersignal (F) zu einer übergeordneten, die Energieübertragungsleitung (21) überwachenden Leitzentrale (110) sendet,
**dadurch gekennzeichnet, dass** der Fehlerindikator (100) regelmäßig oder unregelmäßig zumindest eine lokale Wetterinformation (W), die sich auf das Wetter im Umfeld des Fehlerindikators (100) bezieht, zu der übergeordneten Leitzentrale (110), direkt zu einer anderen Zentraleinrichtung (30) als der Leitzentrale (110) oder mittelbar über die Leitzentrale (110) zu der anderen Zentraleinrichtung (30) übersendet.

2. Verfahren nach Anspruch 1,
**dadurch gekennzeichnet, dass** die zumindest eine lokale Wetterinformation (W) mit demselben Kommunikationsprotokoll und auf demselben Kommunikationskanal übermittelt wird wie das Fehlersignal.

3. Verfahren nach einem der voranstehenden Ansprüche,
**dadurch gekennzeichnet, dass** die zumindest eine lokale Wetterinformation (W) in einer Datenbank eines die Zentraleinrichtung (30) bildenden oder zu dieser gehörenden zentralen Cloudsystems (30) gespeichert und/oder mit Visualisierungsmitteln des zentralen Cloudsystems (30) - allein oder mit anderen Wetterinformationen (W), insbesondere Wetterinformationen (W) anderer Quellen - visualisiert wird.

4. Verfahren nach einem der voranstehenden Ansprüche,
**dadurch gekennzeichnet, dass** die zumindest eine lokale Wetterinformation (W) gemeinsam mit Wetterinformationen (W) aus anderen Quellen zur Erstellung einer Wetterprognose herangezogen wird, die bezüglich des Umfeldes des Fehlerindikators (100) messwertbezogen lokal fundierter ist als eine Wetterprognose ohne die zumindest eine lokale Wetterinformation (W).

5. Verfahren nach einem der voranstehenden Ansprüche,
**dadurch gekennzeichnet, dass** die zumindest eine lokale Wetterinformation (W) im Rahmen eines Prognoseverbesserungsverfahrens weiterverarbeitet wird, bei dem auf der Basis einer zuvor erstellten globalen oder regionalen Wetterprognose und der zumindest einen lokalen Wetterinformation (W) eine lokal modifizierte Wetterprognose, die die zumindest eine lokale Wetterinformation (W) berücksichtigt, erstellt wird.

6. Verfahren nach Anspruch 4 oder 5,
**dadurch gekennzeichnet, dass** die Erstellung der Wetterprognose und/oder das Prognoseverbesserungsverfahren mittels eines künstlichen neuronalen Netzes (200) auf der Basis eines Multilayer-Perzeptronen-Modells oder verwandter Verfahren durchgeführt wird.

7. Verfahren nach Anspruch 6,
**dadurch gekennzeichnet, dass**
- bei dem Prognoseverbesserungsverfahren ein künstliches neuronales Netz (200) mit mindestens drei Schichten genutzt wird, von denen die Eingangsschicht und die Ausgangsschicht des Netzes (200) jeweils über die gleiche Anzahl an Perzeptronen verfügen und wobei jedes Perzeptron eine Variable der Wetterprognose pro Zeitintervall repräsentiert,
- an die Eingangsschicht die zuvor erstellte globale oder regionale Wetterprognose und die lokalen Wetterinformationen (W) eingegeben werden und
- die von dem neuronales Netz (200) ermittelte lokal modifizierte Wetterprognose mittels der Perzeptronen der Ausgangsschicht ausgegeben werden.

8. Verfahren nach einem der voranstehenden Ansprüche,
**dadurch gekennzeichnet, dass** das künstliche neuronale Netz (200) vor der Erstellung der Wetterprognose oder vor der Durchführung des Prognoseverbesserungsverfahrens mit Hilfe der Backpropagation-Methode und gemessenen Wetterinformationen (W), insbesondere solchen des Fehlerindikators, als Trainingsdaten trainiert wird.

9. Verfahren nach einem der voranstehenden Ansprüche,
**dadurch gekennzeichnet, dass**
- der Fehlerindikator (100) oder zumindest dessen Kommunikationsmodul (102) mit Solarenergie betrieben wird, die mittels einer Solarzelle (103) des Fehlerindikators (100) gewonnen wird,
- die jeweilige Leistungsabgabe der Solarzelle (103) als Maß für die jeweilige solare Einstrahlung herangezogen und anhand der jeweiligen Leistungsabgabe ein solarer Einstrahlungsmesswert (SE) erzeugt wird und
- der solare Einstrahlungsmesswert (SE) als die zumindest eine lokale Wetterinformation (W) oder eine der lokalen Wetterinformationen (W) an die Leitzentrale (110) und/oder die Zentraleinrichtung übersandt wird.

10. Verfahren nach einem der voranstehenden Ansprüche,
**dadurch gekennzeichnet, dass** der Fehlerindikator (100) einen oder mehrere Wettersensoren, insbesondere einen Regenmesser (104), einen Windmesser (107), einen Temperaturfühler (105) und/oder Luftdrucksensor (106), aufweist, deren Sensorsignale als lokale Wetterinformationen (W) an die Leitzentrale (110) und/oder die Zentraleinrichtung übersandt werden.

11. Verfahren nach einem der voranstehenden Ansprüche,
**dadurch gekennzeichnet, dass**
- der Fehlerindikator (100) ein Kommunikationsmodul (102), insbesondere Gateway, das zum Senden des Fehlersignals (F) an die Leitzentrale (110) geeignet ist, sowie eine zusätzliche Kommunikationseinrichtung (510), insbesondere Nahfeldkommunikationseinrichtung, umfasst und
- mittels der zusätzlichen Kommunikationseinrichtung (510) eine Datenverbindung, insbesondere in Form einer Funkverbindung, zwischen mindestens einem Strom- und/oder Spannungssensor des Fehlerindikators (100) und dem Kommunikationsmodul (102) des Fehlerindikators (100) und/oder eine Datenverbindung, insbesondere in Form einer Funkverbindung, zwischen mindestens einem externen Wettersensor und dem Kommunikationsmodul (102) des Fehlerindikators unterhalten wird.

12. Verfahren nach einem der voranstehenden Ansprüche,
**dadurch gekennzeichnet, dass**
- zusätzlich zu dem Fehlerindikator (100) weitere Fehlerindikatoren (100) betrieben werden, die
- jeweils dieselbe elektrische Energieübertragungsleitung (21) wie der Fehlerindikator (100) oder eine andere mit dieser mittelbar oder unmittelbar in Verbindung stehende elektrische Energieübertragungsleitung (21) desselben Energieübertragungsnetzes (20) überwachen und im Falle eines Fehlers jeweils mittels ihres Kommunikationsmoduls (102) ein Fehlersignal (F) zu der übergeordneten Leitzentrale (110) senden, und
- jeweils über ihr Kommunikationsmodul (102) regelmäßig oder unregelmäßig zumindest eine lokale Wetterinformation (W), die sich auf das Wetter im Umfeld des jeweiligen Fehlerindikators (100) bezieht, unmittelbar zu einer Zentraleinrichtung oder mittelbar über die Leitzentrale (110) zu der Zentraleinrichtung übersenden, und zwar vorzugsweise jeweils mit demselben Kommunikationsprotokoll und auf demselben Kommunikationskanal, das bzw. der zur Übermittlung der Fehlersignale (F) des Fehlerindikators (100) genutzt wird,
- im Falle eines Empfangs von einem oder mehreren Fehlersignalen (F) die Leitzentrale (110) anhand der Fehlersignale die vom Fehler betroffenen Abschnitte des Energieübertragungsnetzes (20) bestimmt und
- die Zentraleinrichtung die lokalen Wetterinformationen (W) der Fehlerindikatoren (100) weiterverarbeitet, insbesondere
- in einer Datenbank eines zentralen Cloudsystems (30) speichert und/oder
- visualisiert und/oder
- zur Erstellung einer Wetterprognose heranzieht und/oder
- zur Erstellung einer lokal modifizierten Wetterprognose heranzieht, und zwar auf der Basis einer zuvor erstellten globalen oder regionalen Wetterprognose und auf der Basis der lokalen Wetterinformationen (W), die die Zentraleinrichtung von den Fehlerindikatoren (100) erhält.

13. Fehlerindikator (100) zum Erkennen eines Fehlers in einer elektrischen Energieübertragungsleitung (21), insbesondere eines Fehlerstroms in der Energieübertragungsleitung (21), und zum Senden eines Fehlersignals (F) zu einer übergeordneten, die Energieübertragungsleitung (21) überwachenden Leitzentrale (110) im Falle eines erkannten Fehlers,
**dadurch gekennzeichnet, dass** der Fehlerindikator (100) derart ausgestaltet ist, dass er mittels eines Kommunikationsmoduls (102) regelmäßig oder unregelmäßig zumindest eine lokale Wetterinformation (W), die sich auf das Wetter im Umfeld des Fehlerindikators (100) bezieht, zu der übergeordneten Leitzentrale (110), direkt zu einer anderen Zentraleinrichtung (30) oder mittelbar über die Leitzentrale (110) zu der Zentraleinrichtung (30) übersendet.

14. Fehlerindikator (100) nach Anspruch 13,
**dadurch gekennzeichnet, dass**
- der Fehlerindikator (100) einen oder mehrere Wettersensoren aufweist, deren Sensorsignale als lokale Wetterinformationen (W) an die Leitzentrale (110) und/oder die Zentraleinrichtung (30) übersandt werden, und/oder
- der Fehlerindikator (100) derart ausgestaltet ist, dass er dauerhaft oder zeitweise mit einem oder mehreren externen Wettersensoren in einer Kommunikationsverbindung stehen kann und empfangene Sensorsignale der externen Wettersensoren über sein Kommunikationsmodul als lokale Wetterinformationen (W) an die Leitzentrale und/oder die Zentraleinrichtung (30) weiterleitet.

15. Überwachungseinrichtung zur Überwachung eines Energieübertragungsnetzes (20) mit einer Vielzahl an Fehlerindikatoren (100), die elektrische Energieübertragungsleitungen (21) eines Energieübertragungsnetzes (20) überwachen und im Falle eines Fehlers jeweils mittels eines Kommunikationsmoduls (102) ein Fehlersignal (F) zu einer übergeordneten Leitzentrale (110) der Überwachungseinrichtung senden,
**dadurch gekennzeichnet, dass** die Fehlerindikatoren (100) gemäß Anspruch 13 oder 14 ausgebildet sind.
